(19) Europäisches Patentamt

European Patent Office

Office européen des brevets

(11) Veröffentlichungsnummer: **0 455 084 A2**

## (12) EUROPÄISCHE PATENTANMELDUNG

(21) Anmeldenummer: 91106422.8

(22) Anmeldetag: 22.04.91

(51) Int. Cl.⁵: **G01R 31/36**

(30) Priorität: 30.04.90 DE 4013977

(43) Veröffentlichungstag der Anmeldung:
**06.11.91 Patentblatt 91/45**

(84) Benannte Vertragsstaaten:
**AT BE CH ES FR GB GR IT LI LU NL**

(71) Anmelder: **KOTZOLT-LEUCHTEN L & G
KOTZOLT GmbH & Co. KG
Lagesche Strasse 72-76a**

W-4920 Lemgo 1(DE)

(72) Erfinder: **Kotzolt , Michael
Lagesche Str. 72 a
W-4920 Lemgo 1(DE)**

(74) Vertreter: **TER MEER - MÜLLER -
STEINMEISTER & PARTNER
Artur-Ladebeck-Strasse 51
W-4800 Bielefeld 1(DE)**

(54) **Akku-Testvorrichtung für Notbeleuchtungssysteme.**

(57) Eine Akku-Testvorrichtung für Akkus von Notleuchten-Systemen umfaßt einen parallel zu dem Akku (10) angeordneten, beim Test durch Schließung eines Schalters (14) den Akku im wesentlichen kurzschließenden Meßwiderstand (12) mit geringem Widerstandswert, einen die Spannung am Meßwiderstand beim Test erfassenden und verstärkenden Meßverstärker (16), eine Referenzspannungs-Schaltung (18) zur Lieferung einer konstanten Referenzspannung und einen die Spannung am Meßwiderstand und einen die Referenzspannung aufnehmenden Komparator (20), der die Spannungen vergleicht und ein Fehlersignal liefert, wenn die Meßspannung einen vorgegebenen Schwellenwert in bezug auf die Referenzspannung unterschreitet.

EP 0 455 084 A2

Die Erfindung betrifft eine Akku-Testvorrichtung für Akkus von Notbeleuchtungssystemen gemäß dem Oberbegriff des Hauptanspruchs.

Notbeleuchtungssysteme, die beim Netzausfall durch einen Akku gespeist werden, werden oft über längere Zeiträume nicht benötigt. Dies kann dazu führen, daß das Notbeleuchtungssystem im Bedarfsfalle versagt. Zwar werden die Akkus derartiger Systeme mit Hilfe eines immer angeschlossenen Ladegeräts üblicherweise ständig aufgeladen, jedoch ist dies keine absolute Gewähr für eine ausreichende Stromergiebigkeit des Akkus für die in der Regel durch gesetzliche Vorschriften festgelegte Leuchtdauer. So kann beispielsweise die Leistungsfähigkeit der Batterie durch Faktoren wie Alterung, Memory-Effekt etc. eingeschränkt sein. Eine einfache Spannungsmessung liefert hier keine brauchbare Aussage, und eine genaue Kapazitätsmessung würde einen Ausbau des Akkumulators und eine definierte Entladung und Ladung über einen längeren Zeitraum erfordern, wäre also in der Praxis zu aufwendig.

Der Erfindung liegt die Aufgabe zugrunde, eine Testvorrichtung zu schaffen, mit der in verhältnismäßig einfacher Weise rasch festgestellt werden kann, ob eine Batterie in der Lage ist, die angeschlossene Leuchte über den geforderten Zeitraum mit Strom zu versorgen.

Diese Aufgabe wird erfindungsgemäß bei einer Vorrichtung der eingangs genannten Art gelöst durch einen parallel zum Akku angeordneten, beim Test durch Schließung eines Schalters den Akku im wesentlichen kurzschließenden Meßwiderstand mit geringem Widerstandswert, einen die Spannung am Meßwiderstand beim Test erfassenden und verstärkenden Meßverstärker, eine Referenzspannungs-Schaltung zur Lieferung einer konstanten Referenzspannung und einen die Spannung am Meßwiderstand und die Referenzspannung aufnehmenden Komparator, der die Spannungen vergleicht und ein Fehlersignal liefert, wenn die Meßspannung einen vorgegebenen Schwellenwert in bezug auf die Referenzspannung unterschreitet.

Vorzugsweise wird die Zuschaltung des Meßwiderstandes durch ein Zeitglied auf eine relativ kurze Zeit, z.B. 25 ms, begrenzt, damit eine unnötige Belastung der Batterie vermieden wird. Die kurze Testzeit erfordert es andererseits, das Testergebnis zu speichern. Dem Komparator ist daher ein Speicher zum Festhalten des Ausgangssignals des Komparators nachgeschaltet.

Ein weiteres Zeitglied kann dazu vorgesehen sein, den Test automatisch in regelmäßigen Abständen von beispielsweise 24 Stunden einzuleiten. Auf diese Weise ergibt sich eine automatische Selbstkontrolle der Notbeleuchtungsschaltung, die manuelle Tests weitgehend unnötig macht. Gleichwohl kann neben der automatischen Auslösung des Tests auch eine manuelle Auslösung vorgesehen sein.

Die Referenzspannung wird in einer hochgenauen und temperaturkompensierten Schaltung erzeugt, ist also von Umgebungseinflüssen weitestgehend unabhängig.

Die Fehlermeldung kann optisch über eine blinkende Leuchtdiode, akustisch über einen Piezo-Signalgeber sowie über einen potentialfreien Relaiskontakt erfolgen. Auf diese Weise kann die Testvorrichtung an ein Rechnersystem angeschlossen werden.

Die Testvorrichtung ist eine eigenständige Einheit, die lediglich eine Betriebsspannung und die Batteriespannung benötigt.

Einzelheiten der Ladeschaltung zum ständigen Aufladen der Batterie werden hier nicht geschildert. Im allgemeinen wird der Ladestrom unabhängig vom Akku-Typ so gewählt, daß er nach mindestens 20 Stunden eine ausreichende Ladung herbeiführt, die zum Betreiben der Notleuchte über die vorgeschriebene Zeit benötigt wird. In der Ladeschaltung können sich weitere Testeinrichtungen befinden, die einen Ausfall des Ladestroms oder einen Fadenbruch des Leuchtmittels anzeigen.

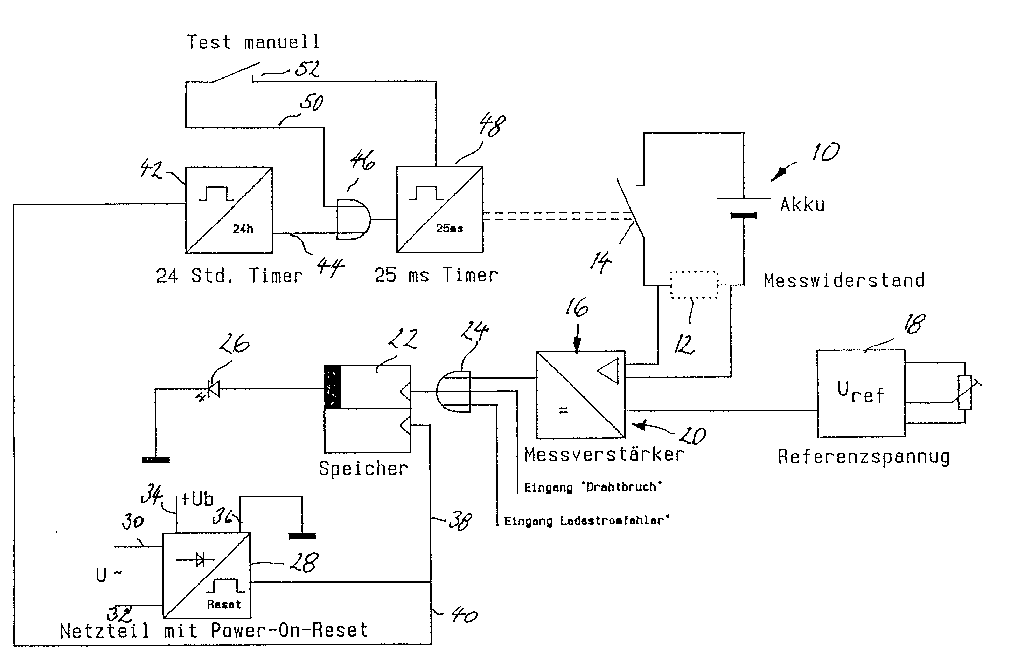

Die einzige Figur ist ein Blockschaltbild der wesentlichen Elemente der erfindungsgemäßen Vorrichtung.

Das Blockschaltbild enthält nur die mit dem Akku-Test im engeren Sinne zusammenhängenden Elemente, nicht dagegen Einzelheiten des gesamten Notbeleuchtungssystems, der Ladeschaltung etc. Ein Akku 10 kann über einen Meßwiderstand 12 kurzgeschlossen werden, sofern ein Schalter 14 geschlossen wird. Der Meßwiderstand 12 hat einen sehr geringen Widerstandswert, bewirkt also einen fast vollständigen Kurzschluß.

Die beim Test auftretende Spannung am Meßwiderstand 12 wird durch einen Meßverstärker 16 erfaßt und verstärkt. Der Meßverstärker 16 nimmt zugleich eine Referenzspannung einer Referenzspannungsschaltung 18 auf, die eine weitestgehend konstante Spannung liefert. Die beiden Spannungen werden in einem Komparator 20, der ebenfalls in der in der Zeichnung mit 16 bezeichneten Schaltung enthalten ist, verglichen. Unterschreitet die Meßspannung einen vorgegebenen Schwellenwert, so wird ein Fehlersignal an einen Speicher 22 geliefert, der das Meßergebnis bis zum nächsten Abschalten des Netzes festhält. Dem Speicher 22 ist ein logisches Glied 24 vorgeschaltet, das dem Speicher zugleich Fehlersignale zuführt, die einen Fadenbruch des verwendeten Leuchtmittels oder einen Fehler des Ladestroms anzeigen. Liegt ein Fehlersignal vor, so wird eine Blinkdiode 26 in Gang gesetzt.

Mit 28 ist ein Netzteil der Vorrichtung bezeichnet, das über die Klemmen 30,32 mit dem Netz verbunden ist und an den Klemmen 34,36 eine Betriebsspannung Ub liefert. Das Netzteil 28 ermöglicht zugleich über eine mit "Reset" bezeichnete Rückstelltaste und eine Leitung 38 eine Rückstellung des Speichers 22 und eine Leitung 40 eine Rückstellung eines Zeitgliedes 42. Dieses Zeitglied 42 gibt beispielsweise in Abständen von 24 Stunden über einen Ausgang 44 einen Impuls zur Auslösung eines Tests ab. Der Ausgang 44 ist über ein logisches Glied 46 mit einem weiteren Zeitglied 48 verbunden, das über einen sehr kurzen Zeitraum von beispielsweise 25 ms eine Schließung des Schalters 14 ermöglicht. Diese zeitliche Begrenzung auf etwa 25 ms erfolgt zur Schonung des Akkus 10. Wenn also über den Ausgang 44, das logische Glied 46 und das Zeitglied 48 der Schalter 14 kurzfristig geschlossen wird, läuft ein Testzyklus der zuvor beschriebenen Art ab.

Das logische Glied 46 ist dazu vorgesehen, den nicht bezeichneten Eingang des Zeitgliedes 48 zugleich mit einer Leitung 50 zu verbinden, die über einen Schalter 52 eine manuelle Auslösung eines Tests gestattet.

Der Meßwiderstand 12 enthält vorzugsweise einen Feldeffekt-Transistor mit niedrigem Durchlaßwiderstand und niedriger Ansteuerungsspannung. Die Notwendigkeit einer niedrigen Ansteuerspannung ergibt sich aus der zur Verfügung stehenden Versorgungsspannung. Es muß gewährleistet sein, daß bei minimaler Versorgungsspannung der maximal mögliche Teststrom fließen kann.

Der niedrige Durchlaßwiderstand ermöglicht eine kurzzeitige maximale Belastung des Akkus, ohne diesen nennenswert zu entladen. Außerdem muß der Transistor einen hohen Impulsstrom zulassen.

Gegenüber einem Meßwiderstand anderer Art existiert bei dieser Lösung ein erheblicher Platzvorteil sowie ein besseres Temperaturverhalten.

Bei Transistoren der genannten Art ergeben sich beispielsweise folgende Werte: I = 17 A, U = 4 V, gepulster Drainstrom maximal 40 A.

Der Transistor ermöglicht es, durch den erzeugten Spannungsabfall sichere Rückschlüsse auf den Akku-Zustand zu ziehen. Der Transistor zeichnet sich dadurch aus, daß im geschaltetem Zustand sehr stabile und von Fertigungstoleranzen unabhängige elektrische Werte erreicht werden. Er läßt einen hohen Strom zur Belastung des Akkus zu, ohne dabei seine Werte zu verändern.

**Patentansprüche**

1. Akku-Testvorrichtung für Akkus von Notleuchten-Systemen, **gekennzeichnet** durch einen parallel zu dem Akku (10) angeordneten, beim Test durch Schließung eines Schalters (14) den Akku im wesentlichen kurzschließenden Meßwiderstand (12) mit geringem Widerstandswert, einen die Spannung am Meßwiderstand beim Test erfassenden und verstärkenden Meßverstärker (16), eine Referenzspannungs-Schaltung (18) zur Lieferung einer konstanten Referenzspannung und einen die Spannung am Meßwiderstand und einen die Referenzspannung aufnehmenden Komparator (20), der die Spannungen vergleicht und ein Fehlersignal liefert, wenn die Meßspannung einen vorgegebenen Schwellenwert in bezug auf die Referenzspannung unterschreitet.

2. Testvorrichtung nach Anspruch 1, dadurch **gekennzeichnet**, daß die Zuschaltung des Meßwiderstandes (12) durch ein Zeitglied (48) auf eine relativ kurze Zeit, z.B. 25 ms, begrenzt ist und daß dem Komparator (20) ein Speicher (22) zum Festhalten des Ausgangssignals des Komparators nachgeschaltet ist.

3. Testvorrichtung nach Anspruch 1 oder 2, **gekennzeichnet** durch ein Zeitglied (42), das den Test durch Zuschalten des Meßwiderstandes (12) automatisch in regelmäßigen Abständen, z.B. 24 Stunden, automatisch auslöst.

4. Testvorrichtung nach einem der Ansprüche 1 bis 3, dadurch **gekennzeichnet**, daß der Meßwiderstand (12) einen Feldeffekt-Transistor mit niedrigem Durchlaßwiderstand und niedriger Ansteuerspannung umfaßt.

EP 0 455 084 A2